# EUROPEAN PATENT APPLICATION

(11) **EP 3 327 801 A1**
(43) Date of publication of application: **30.05.2018**
(21) Application number: 16382559.9
(22) Date of filing: 24.11.2016
(51) Int. Cl.: H01L 33/48, H01L 33/62, H01L 33/00, H01L 33/64

(54) **ELECTRONIC ASSEMBLY AND METHOD FOR CREATING AN ELECTRONIC ASSEMBLY**

(71) Applicant: VALEO ILUMINACION, 23600 Martos (ES)
(72) Inventor: TEBA, Daniel, 23600 MARTOS (ES); GUZMAN, Alfonso-Manuel, 23560 HUELMA (ES); MARTINEZ, Francisco, 18500 GUADIX (Granada) (ES)

(57) **Abstract**

The invention provides an electronic assembly (1) comprising a plastics substrate (2), a conductive track (3) directly deposited on the plastics substrate (2), a conductive welding material (4) in direct contact with the conductive track (3), a semiconductor light source (5); and a conductive wire (6) electrically connecting the semiconductor light source (5) and the conductive welding material (4). The invention also provides a method for manufacturing such an electronic assembly (1).

## Description

### TECHNICAL FIELD

The present invention belongs to the field of electronic assemblies comprising conductive tracks directly deposited on a plastics substrate.

### STATE OF THE ART

Directly depositing a conductive track on a plastics substrate normally supposes substantial cost savings, mainly due to the fact that a dedicated printed circuit board need not be provided. Therefore, other integral parts of the device to be controlled with the electronic assembly can be taken advantage of to play the role of substrate for the conductive track.

Furthermore, the process of direct deposition of the conductive track usually implies shorter manufacturing times and conductive material savings - in contrast to most PCB manufacturing methods, there is no need for removing regions of conductive material or for using an additional product, such as an electrolyte, to define the conductive track.

Wire bonding is a known method to place a light emitting diode (LED) in a printed circuit board (PCB). However, when LED is to be electrically connected to a conductive track which has been directly deposited on a plastics substrate, wire bonding cannot be used as, due to some particular features of this conductive track: firstly, the directly deposited conductive track is usually a surface with a poor finish, so the wire does not stick very well to it, and there is a risk of the wire being detached. Secondly, the directly deposited conductive track is very thin and fragile, so if it is pressed to create a suitable attachment between the wire and the track or if it is subjected to the ultrasonic wire bonding, it may crack, thus producing a discontinuity.

As a consequence, it would be desirable to find a method that could make it possible to place a high power light source on a conductive track which has been directly deposited on a plastics substrate.

### DESCRIPTION OF THE INVENTION

The invention provides a solution for this problem by means of an electronic assembly according to claim 1, a method for creating an electronic assembly according to claim 9 and a lighting device for automotive vehicle according to claim 14. Preferred embodiments of the invention are defined in dependent claims.

In an inventive aspect, the invention provides an electronic assembly comprising
a plastics substrate;
a conductive track directly deposited on the plastics substrate;
a conductive welding material in direct contact with the conductive track;
a semiconductor light source; and
a conductive wire electrically connecting the semiconductor light source and the conductive welding material.

Direct deposition of a conductive track on a plastics substrate should be construed as forming the final shape of the conductive track on the plastics substrate without the need for removing metal or for any other intermediate element, such as a mask, an electrolyte or any other chemical bath or a photosensitive film. The conductive track is just directly placed on the plastics substrate.

This electronic assembly solves the problem of connecting a semiconductor light source with a conductive track in the cases where the conductive track is directly deposited on a plastics substrate.

In some particular embodiments, the electronic assembly further comprises a heat sink supporting the plastics substrate and the semiconductor light source, the semiconductor light source being in thermal contact with the heat sink.

The thermal contact between the light source and the heat sink should be understood in the sense that the lighting device enables heat transfer between the light source and the heat sink, either by direct contact or by means of an intermediate element. This thermal contact may be embodied in some different ways. In some embodiments, the lighting device would comprise a plastic substrate with a conductive track directly deposited on it and the light source being placed in direct contact with the heat sink but electrically connected to the conductive track. In some embodiments, the lighting device would comprise a printed circuit board comprising the circuit tracks, with the light source also comprised in it, the light source being in thermal contact with the heat sink by means of this printed circuit board.

The heat sink provides heat dissipation for the semiconductor light source. This feature extends the lifespan of the semiconductor light source.

In some particular embodiments, the semiconductor light source is in thermal contact with the heat sink by means of a conductive adhesive material.

This way of attaching the semiconductor light source to the heat sink is advantageous, because it is easy and cheap, and ensures a correct heat dissipation between the semiconductor light source and the heat sink. The conductive adhesive material may be a conductive glue or any similar compound, as far as it mechanically fixes the semiconductor light source to the heat sink and is adapted to conduce heat between these elements.

In some particular embodiments, the conductive welding material is placed on a first end of the conductive track.

When the welding material is placed in that position, the necessary amount of welding material is lower.

In some particular embodiments, the electronic assembly comprises:
a plurality of conductive tracks directly deposited on the plastics substrate;
a plurality of conductive welding materials being in direct contact with the plurality of conductive tracks, each welding material being in direct contact with a single conductive track;
a plurality of semiconductor light sources; and
a plurality of conductive wires electrically connecting the plurality of semiconductor light sources with the plurality of conductive welding materials, each conductive wire electrically connecting a single semiconductor light source with a single conductive welding material;
   such electronic assembly additionally comprising a non-conductive wall between at least two of the conductive welding materials.

This embodiment is suitable when more than one high power semiconductor light source is needed, such as in the case of lighting applications where two or three high power LEDs are needed to provide the lighting features of an automotive vehicle.

In a particular embodiment, the conductive welding material is either a conductive glue or a welding paste.

These ways of providing the conductive welding material are the most suitable for this function, although other ways may be used as well in different embodiments.

In a particular embodiment, the conductive welding material comprises at least one of Sn, Bi or Ag.

These elements are the most suitable for the conductive welding material, although other materials may be used as well for this function in different embodiments.

In a particular embodiment, the plastics substrate is three-dimensional.

A three-dimensional plastics substrate should be construed as a plastics substrate whose surface on which the conductive track extends is not completely contained in a plane. Direct deposition is particularly appropriate for such three-dimensional surfaces, in comparison to other known techniques which normally require planar surfaces for printing a circuit board.

This device is suitable for being used in several applications, where a three-dimensional plastics substrate is required to provide lighting in a more complex environment.

In a particular embodiment, the conductive wire is connected to the semiconductor light source through light source electrodes. These electrodes ensure a correct coupling and provide the conductive wire with a more suitable coupling location.

In another inventive aspect, the invention provides a method for creating an electronic assembly according to any of preceding claims, the method comprising the steps of:
providing a semiconductor light source;
providing a plastics substrate;
directly depositing a conductive track on the plastics substrate;
depositing a conductive welding material in direct contact with the conductive track;
placing a conductive wire in electric contact both with the semiconductor light source and with the conductive welding material.

This method solves the problem of connecting a semiconductor light source with a conductive track in the cases where the conductive track is directly deposited on a plastics substrate.

In some particular embodiments, the step of depositing a conductive track is carried out by a plasma flow containing metal dust particles. This step may be carried out, for instance, using the device described in document US 2015/174686 A1, and concretely in its claim 1.

This particular embodiment provides an advantageous way of depositing a conductive track directly on a plastics substrate.

In some particular embodiments, the method further comprises the steps of providing a heat sink, and attaching the semiconductor light source in thermal contact with the heat sink.

The provision of a heat sink is important to provide heat dissipation for the lighting device.

In some particular embodiments, the method further comprises the step of welding with ultrasonics the conductive wire to the conductive track by means of the conductive welding material.

Ultrasonic welding is suitable for this method, since it is easy and produces a good result. It may happen that ultrasonic welding may jeopardize the continuity of electric flow along the conductive track in the point where the welding takes place. However, this do not affect correct operation of the electronic assembly produced by the method, as, in the event the electrical continuity is interrupted, the conductive welding material serves as a conductive bypass for the electric flow, thus ensuring correct operation of the electric assembly.

In some particular embodiments, the method further comprises the step of curing the conductive welding material after the conductive wire is placed.

This step is suitable when the conductive welding material requires a curing stage to perform its function providing attachment and electric connection between the conductive wire and the conductive track.

In another inventive aspect, the invention provides a lighting device for automotive vehicle comprising
an electronic assembly according to the previous inventive aspect;
an optical element suitable for receiving light emitted by the light source and for shaping the light into a light pattern projected outside the lighting device; and
a housing accommodating the electronic assembly and the optical element.

An optical element is an element that has some optical properties to receive a light beam and emit it in a certain direction and/or shape, as a person skilled in automotive lighting would construe without any additional burden. Reflectors, collimators, light guides, projection lenses, etc., or the combination thereof are some examples of these optical elements. Lighting devices for automotive vehicles can benefit from the use of electronic assemblies comprising conductive tracks directly deposited on a plastics substrate. In the first place, a wide range of the lighting device's parts can be used either as plastics substrate or as base for the plastics substrate (in which case the plastics substrate may for instance coat the base), taking into account that even three-dimensional plastics substrates are suitable for direct deposition of conductive tracks. Therefore, a dedicated printed board circuit is not required, which leads to reducing the cost and the weight of the lighting device. As was stated above, cost savings are even more significant due to the fact that direct deposition does not normally want removing conductive material to shape the conductive tracks.

### BRIEF DESCRIPTION OF THE DRAWINGS

To complete the description and in order to provide for a better understanding of the invention, a set of drawings is provided. Said drawings form an integral part of the description and illustrate an embodiment of the invention, which should not be interpreted as restricting the scope of the invention, but just as an example of how the invention can be carried out. The drawings comprise the following figures:
Figure 1 shows an electronic assembly 1 according to the invention.
Figure 2 shows an alternative embodiment of an electronic assembly 1 according to the invention.
Figure 3 shows a lighting device 10 comprising an electronic assembly 1 according to the invention.
Figures 4a to 4c illustrate some of the steps of a method for creating such an electronic assembly 1.

### DETAILED DESCRIPTION OF THE INVENTION

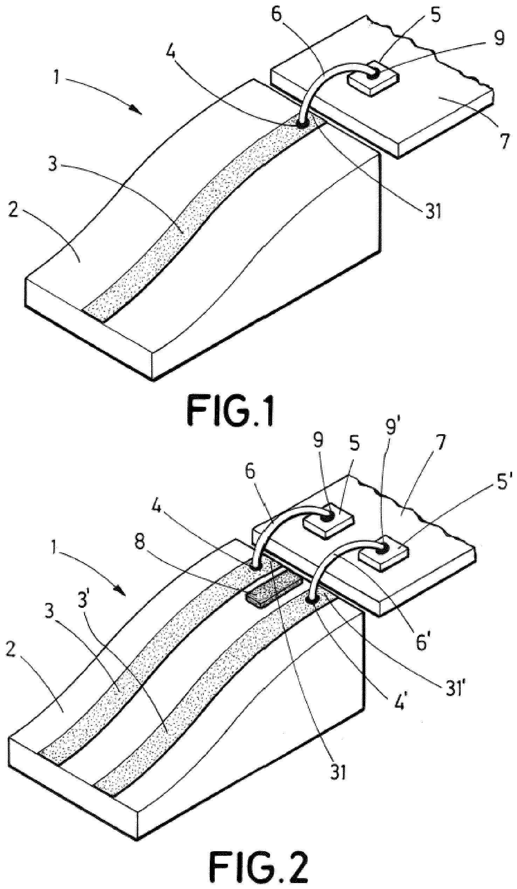

Figure 1 shows an electronic assembly 1 according to the invention. This electronic assembly 1 comprises
a three-dimensional plastics substrate 2;
a conductive track 3 directly deposited on the three-dimensional plastics substrate 2;
a conductive welding material 4 in direct contact with the conductive track 3;
a semiconductor light source 5;
a conductive wire 6 electrically connecting the semiconductor light source 5 and the conductive welding material 4; and
a heat sink 7 supporting the three-dimensional plastics substrate 2 and the semiconductor light source 5, the heat sink 7 being in thermal contact with the semiconductor light source 5.

The electric contact between the semiconductor light source 5 and the conductive track 3 is therefore enabled. The conductive wire 6 acts as an electric connector between the semiconductor light source 5 and the conductive track 3, while the conductive welding material 4 is used as an intermediate material to provide this electric connection, in a way that is compatible with the features of the conductive track 3, which is directly deposited on the three-dimensional plastics substrate 2.

The semiconductor light source 5 is in thermal contact with the heat sink 7 by means of a conductive adhesive material (not shown), which is deposited in the base of the semiconductor light source 5 providing the heat dissipation from the semiconductor light source 5 to the heat sink 7.

The conductive wire 6 is connected to the semiconductor light source 5 through light source electrodes 9. These light source electrodes 9, which are comprised in the light source, provides a safe connection.

The conductive welding material 4 is placed on a first end 31 of the conductive track 3. As the semiconductor light source 5 should not be directly connected to the conductive track 3, it is preferable to minimize the size of the conductive wire 6 so that the semiconductor light source 5 is placed near a first end 31 of the conductive track 3.

Figure 2 shows an alternative embodiment of an electronic assembly 1 according to the invention. In this figure, the electronic assembly 1 is similar to the one shown in figure 1, except in that it comprises
two conductive tracks 3, 3' directly deposited on the three-dimensional plastics substrate 2;
two conductive welding materials 4, 4' each in direct contact with a different one of the two conductive tracks 3, 3' and located in a first end 31, 31' of the conductive track 3, 3';
two semiconductor light sources 5, 5';
two conductive wires 6, 6', each one electrically connecting one of the semiconductor light sources 5, 5', by means of its electrodes 9, 9', to a different one of the two conductive welding materials 4, 4'; and
   a non-conductive wall 8 between the two different pieces of conductive welding material 4, 4'.

In some particular embodiments, the conductive welding material 4, 4' is supplied in the form of a conductive glue or a welding paste, and it comprises at least one of Sn, Bi or Ag.

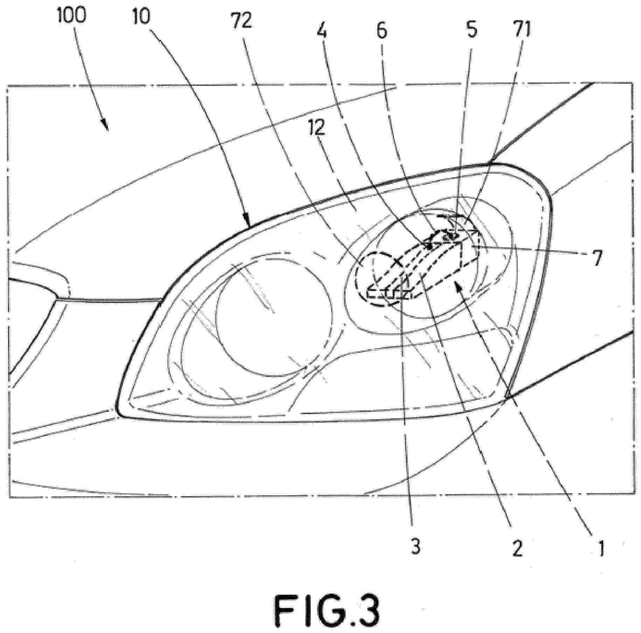

Figure 3 shows a lighting device 10 installed in an automotive vehicle 100, the lighting device 10 comprising
an electronic assembly 1 according to the invention;
a reflector 71, and a projection lens 72, suitable for receiving light from the semiconductor light source 5 and projecting it in the shape of a light pattern in a forward direction; and
a housing 12 accommodating the electronic assembly 1, the reflector 71 and the projection lens 72.

The forward direction should be understood as the advance direction of an automotive vehicle where the lighting device is intended to be installed.

In the particular embodiment shown in this figure, the optical elements include a reflector 71 and a projection lens 72. The reflector 71 is placed in the electronic assembly 1, arranged to reflect the light emitted by the semiconductor light source 5. The projection lens is in turn located in a forward position with respect to the lighting device 10, and receives the light from the semiconductor light source 5 which has been reflected by the reflector 71. The projection lens 72 orientates this received light according to the vehicle advancing direction.

These optical elements 71, 72 makes the lighting device 11 suitable for being installed in an automotive vehicle 100 and able to perform lighting functions, such as high-beam and low-beam.

The electronic assembly 1 is able to be used when the semiconductor light source cannot be directly located on a directly deposited conductive track, being therefore more versatile, taking advantage on the benefits of the directly deposited conductive track and from the benefits of locating the semiconductor light source separate from the conductive track.

This lighting device 10 may be incorporated in an automotive vehicle 100, being able to adapt to difficult space requirements.

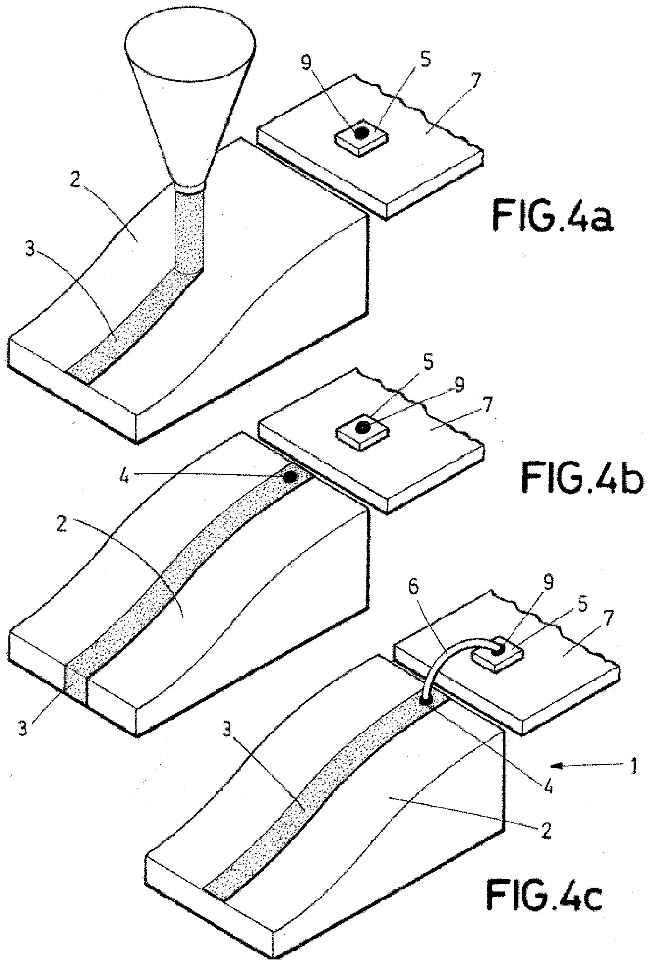

Figures 4a to 4c illustrate some of the steps of a method for creating such an electronic assembly 1. This method comprises the steps of:
providing a semiconductor light source 5 in thermal contact with a heat sink 7;
providing a three-dimensional plastics substrate 2;
directly depositing a conductive track 3 on the three-dimensional plastics substrate 2 by means of plasma deposition of metal dust particles;
depositing a conductive welding material 4 in direct contact with the conductive track 3;
placing a conductive wire 6 in electric contact both with the semiconductor light source 5, by means of its electrode 9, and to the conductive welding material 4.

Figure 4a shows the first three steps of this method, with metal dust particles being deposited on a three-dimensional plastics substrate 2 to form a conductive track 3, and the provision of a semiconductor light source 5 in thermal contact with a heat sink 7.

Figure 4b shows the following step of this method, when a conductive welding material 4 is deposited in direct contact with the conductive track 3.

Figure 4c shows the following step of this method, when a conductive wire 6 is placed in electric contact both with the semiconductor light source 5 and to the conductive welding material 4. Then, the conductive wire 6 is welded with ultrasonics to the conductive track 3 by means of the conductive welding material 4.

In some embodiments, where the conductive welding material 4 needs so, this method further comprises the step of curing the conductive welding material 4 after the conductive wire 6 is placed.

## Claims

1. Electronic assembly (1) comprising
a plastics substrate (2);
a conductive track (3) directly deposited on the plastics substrate (2);
a conductive welding material (4) in direct contact with the conductive track (3);
a semiconductor light source (5); and
a conductive wire (6) electrically connecting the semiconductor light source (5) and the conductive welding material (4).

2. Electronic assembly (1) according to claim 1, further comprising a heat sink (7) supporting the plastics substrate (2) and the semiconductor light source (5), the semiconductor light source (5) being in thermal contact with the heat sink (7).

3. Electronic assembly (1) according to claim 2, wherein the semiconductor light source (5) is in thermal contact with the heat sink (7) by means of a conductive adhesive material.

4. Electronic assembly (1) according to any of preceding claims, wherein the conductive welding material (4) is placed on a first end (31) of the conductive track (3).

5. Electronic assembly (1) according to any of preceding claims, comprising
a plurality of conductive tracks (3, 3') directly deposited on the plastics substrate (2);
a plurality of conductive welding materials (4, 4') being in direct contact with the plurality of conductive tracks (3, 3'), each welding material being in direct contact with a single conductive track;
a plurality of semiconductor light sources (5, 5'); and
a plurality of conductive wires (6, 6') electrically connecting the plurality of semiconductor light sources (5, 5') with the plurality of conductive welding materials (4, 4'), each conductive wire electrically connecting a single semiconductor light source with a single conductive welding material;
such electronic assembly additionally comprising a non-conductive wall (8) between at least two of the conductive welding materials (4, 4').

6. Electronic assembly (1) according to any of preceding claims, wherein the conductive welding material (4) is either a conductive glue or a welding paste.

7. Electronic assembly (1) according to any of preceding claims, wherein the conductive welding material (4) comprises at least one of Sn, Bi or Ag.

8. Electronic assembly (1) according to any of preceding claims, wherein the plastics substrate (2) is three-dimensional.

9. Electronic assembly (1) according to any of preceding claims, wherein the conductive wire (6) is connected to the semiconductor light source (5) through light source electrodes (9).

10. Method for creating an electronic assembly (1) according to any of preceding claims, the method comprising the steps of:
providing a semiconductor light source (5);
providing a plastics substrate (2);
directly depositing a conductive track (3) on the plastics substrate (2);
depositing a conductive welding material (4) in direct contact with the conductive track (3);
placing a conductive wire (6) in electric contact both with the semiconductor light source (5) and with the conductive welding material (4).

11. Method according to claim 10, wherein the step of depositing a conductive track is carried out by a plasma flow containing metal dust particles.

12. Method according to any of claims 10 to 11, further comprising the steps of providing a heat sink (7), and attaching the semiconductor light source (5) in thermal contact with the heat sink (7).

13. Method according to any of claims 10 to 12, further comprising the step of welding with ultrasonics the conductive wire (6) to the conductive track (3) by means of the conductive welding material (4).

14. Method according to any of claims 10 to 13, further comprising the step of curing the conductive welding material (4) after the conductive wire (6) is placed.

15. Lighting device (10) for automotive vehicle comprising
an electronic assembly (1) according to any of claims 1 to 9;
an optical element (71, 72) suitable for receiving light from the light source (5) and projecting it in the shape of a light pattern in a forward direction; and
a housing (12) accommodating the electronic assembly (1) and the optical element (71, 72).
